# EUROPEAN PATENT APPLICATION

(11) **EP 4 276 481 A1**
(43) Date of publication of application: **15.11.2023**
(21) Application number: 22173338.9
(22) Date of filing: 13.05.2022
(51) Int. Cl.: G01R 31/26, G01R 31/52

(54) **TRANSIENT VOLTAGE SUPPRESSOR CONDITION MONITORING**

(71) Applicant: Hamilton Sundstrand Corporation, Charlotte, NC 28217-4578 (US)
(72) Inventor: CHAI, Huazhen, Caledonia, 61011 (US)
(74) Representative: Dehns

(57) **Abstract**

A method and system for monitoring a change in leakage current through a transient voltage suppressor, TVS, device, the method comprising locating a tunnel magneto-resistance, TMR, device in proximity to the TVS device and measuring the change in resistance of the TMR device.

## Description

### TECHNICAL FIELD

The present disclosure relates to monitoring the health of a transient voltage suppressor.

### BACKGROUND

Voltage and current transients due to e.g. switching operations, AC line fluctuations, lightning surges and electrostatic discharge are major sources of IC or component failure in electrical systems. Transient voltage suppressors (TVS), also referred to as transorbs, surge arrestors, MOVs etc., are known to provide protection against damage due to such transients. In vehicles e.g. aircraft, several electronic systems are often present which include sensitive electronic devices and components. Exposed parts of these systems may be susceptible to lightning strikes or other sources of transient surges. A TVS may be provided to shunt any power surges to ground thus away from the electronic devices. Whilst TVSs are effective in protecting systems against the effect of voltage surges, they tend to degrade over time or when exposed to a large number of surges. With such degradation, the TVS may become less effective or ineffective in shunting power surges to ground. In many applications e.g. in aircraft or vehicles, it is important to monitor for degradation of the TVS. This is, however, difficult and costly.

One way of monitoring for degradation of a TVS is to periodically remove it from the system and check it when the TVS is not in operation mode (or during power down, or before power up) with a Built-In Test (BIT) circuit, but this requires downtime of the system (and, therefore, the aircraft for a TVS used in an aircraft) which is time and cost intensive. Another method used to monitor a TVS is to include in the electrical system a counter to monitor the number of discharge activities to estimate when the TVS should be replaced. A threshold count is set for the TVS and when this count is reached, the device is replaced. A problem with this approach is that only main discharge activities from lightning or severe over-voltage transients are counted. Gradual degradation of the TVS may also occur due to minor high frequency spikes, aging and other environmental conditions and these are not taken into account by the counter, meaning that the TVS can actually be more degraded than expected from the activity count or the threshold count has to be set artificially low which may result in TVSs being replaced sooner than needed.

Another method of testing the condition of a TVS involves identifying a baseline leakage current for a new TVS and then periodically injecting a stimulation voltage into the TVS and measuring its leakage current. This is compared to the baseline leakage current. An increase leakage current is indicative of degradation of the TVS. A problem with this approach is that the test can only be performed when the TVS is not powered or not in service as it may otherwise affect operation of the system.

Because of the degradation of the TVS and that it is typically complex and time and cost intensive to monitor the condition of a TVS using these known methods, many applications e.g. aerospace applications, prefer to use a more complex over-voltage protection circuit, that avoid using TVS, instead of a simple passive TVS component. Such active circuits, including voltage regulators or clamp circuits do not suffer from degradation like the simple passive TVS component and so are more reliable. This reliability is, however, at the expense of greater complexity, size and cost.

There is, therefore, a need for a way of monitoring the condition of a simple passive TVS device in a simple, quick and reliable manner.

### SUMMARY

According to the disclosure, there is provided a method of monitoring a change in leakage current through a transient voltage suppressor, TVS, device, the method comprising locating a tunnel magneto-resistance, TMR, device in proximity to the TVS device and measuring the change in resistance of the TMR device.

According to another aspect, there is provided an system for monitoring the leakage current through a transient voltage suppression, TVS, device, the system comprising the TVS device connected in a current conduction path and a tunnel-magnet-resistance, TMR, device located proximate the TVS device, and means for measuring changes in the resistance of the TMR device during operation of the TVS device.

### BRIEF DESCRIPTION

Examples of the method and assembly of the disclosure will now be described with reference to the drawings. It is to be noted that variations are possible within the scope of the claims.
Figure 1 shows an example of a simple TVS to which the method of this disclosure can be applied.
Figure 2 illustrates the behaviour of a TMR device.
Figure 3 shows an example of how the TVS condition can be monitored according to the disclosure.
Figure 4 shows one example of monitoring the TVS condition according to the disclosure.
Figure 5 shows an alternative example of monitoring the TVS condition according to the disclosure.

### DETAILED DESCRIPTION

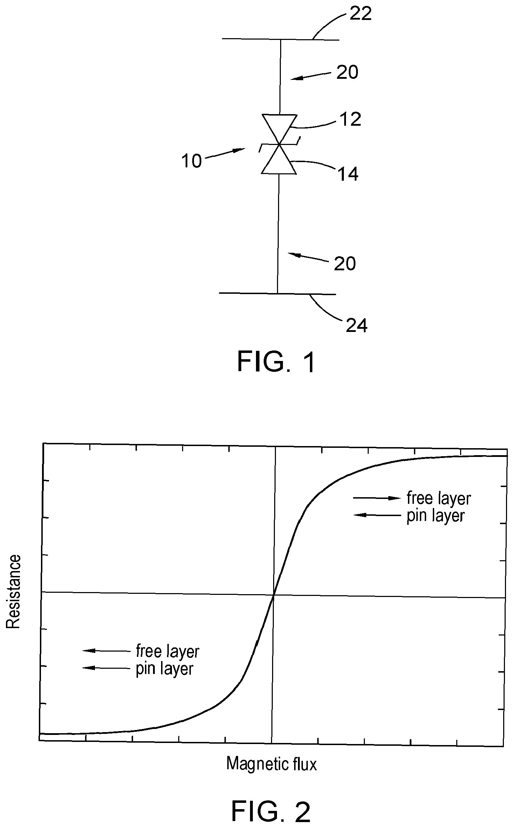

According to this disclosure, the condition/degradation of a TVS for example a TVS as shown in Fig. 1, is monitored using a tunnel magneto-resistance (TMR) device which is located in proximity to the TVS being monitored. Degradation of the TVS causes a change in the resistance of the TMR device, as described further below, and so can be measured by measuring characteristics of the TMR device. This enables the condition of the TMR to be reliably monitored in a simple and passive manner even while the system is in operation.

Referring first to Fig. 1 for a brief description of a TVS, a typical TVS 10 is formed of two back-to-back Zener diodes 12, 14 connected in a bus bar 20 or other conductor of an electrical system between two power lines 22, 24 (which may be ac or dc). The conductor may be a pwb trace, cable wire or other conductor. The TVS 10 is a passive non-linear device that acts as a shunt for voltage surges from e.g. lightning or over-voltage transients. Such TVS devices, as shown here or having other known designs are well-known and will not be described further.

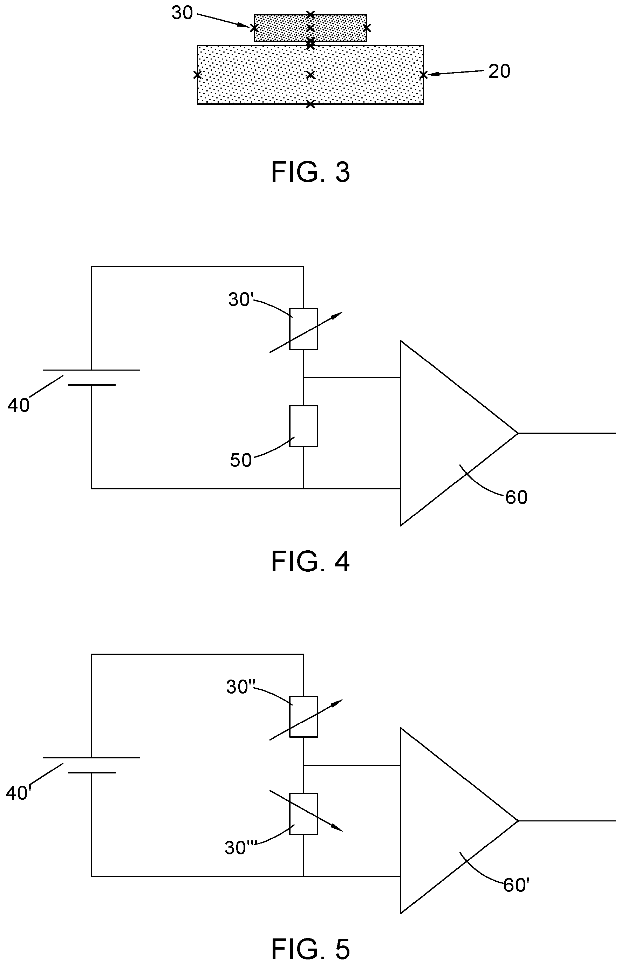

The present disclosure makes use of a TMR sensor or device 30 positioned in proximity to the bus bar/conductor 20 where the TVS 10 is located, as shown in Fig. 3 and discussed further below.

A TMR device is a two-layer chip formed of two ferro-magnetic layers separated by a very thin insulating spacer that allows a tunnel current to flow between the two ferromagnetic layers. As described further below, the TMR device is a flux sensor and so when current flows in the TVS adjacent the TMR device, this is detected by the TMR and the resistance of the TMR changes accordingly. Whilst not currently sufficiently sensitive for accurately measuring absolute current values, a TMR provides a measurable and sufficiently response change in resistance in response to a change in magnetic flux caused by current flowing through the TVS.

The measured resistance of the TMR can be compared, continuously or periodically, to baseline values of TMR resistance determined when the TVS was new, and the result of the comparison - i.e. the change in resistance - is indicative of the degree of degradation of the TVS.

Figure 2 shows how the resistance of the TMR device changes with changing magnetic flux. As mentioned above, the TMR device comprises two layers - one of these layers is pinned, and the other is free. This means that the magnetic orientation of one layer is pinned or fixed in one direction and remains so irrespective of the flux. In the other layer, the orientation of the electrons is not fixed. The orientation of these free electrons will change responsive to an applied magnetic flux. In the graph on Fig. 2, at low flux, the free layer orientation is aligned with the pinned layer i.e. the electron states in the two layers are of the same spin type and the resulting resistance of the TMR device to current flow through the device is low. As flux increases, the orientation of the free layer changes until the fee layer is in the opposite orientation to the pinned layer, therefore, current flowing through the layers is low and, therefore, the tunnel resistance across the layers is high. The resistance changes with applied flux as shown in Fig. 2.

This property of the TMR device can be used to monitor the degree of degradation of a TVS connected in a conductor of an electrical system, located in proximity to the TMR such that a change in current through the TVS - i.e. the leakage current - generates a change in flux generated by the TVS that causes a resultant change in resistance of the adjacent TMR device. This change is compared to the baseline resistance to provide an indication of the increase in leakage current through the TVS and, consequently, an indication of degradation of the TVS.

The TMR needs to be located in proximity to the TVS to be able to pick up the generated flux. Fig. 3 shows an example of a TMR device 30 placed close to the bus bar 20 or other conductor to which the TVS is connected. Other arrangements or placement of the TMR is, of course, possible.

The resistance of the TMR can be measured in various ways. One example is shown in Fig. 4 which uses a reference voltage source 40 across which is connected the TMR sensor 30' and a resistor 50, in series to form a voltage divider. An operational amplifier 60 is connected at its input across the resistor 50. When the resistance of the TMR 30' changes, the voltage across the resistor 50, detected by the op-amp 60 changes accordingly. This change is amplified by the op-amp 60 and outputs a voltage signal that is indicative of the TMR resistance and, therefore, of the TVS leakage current that caused the change in resistance.

An alternative circuit for measuring the TMR resistance and, therefore, degradation, is shown in Fig. 5. This is similar to the circuit of Fig. 4 except that instead of the voltage divider formed by the TMR sensor 30' and a resistor 50, it is formed by a pair of oppositely directed TMRs 30", 30‴ in a push-pull arrangement. When the leakage current of the TVS changes, the resistance of both TMRs will change causing a greater change in the voltage input to the op-amp 60' and, therefore, providing a larger voltage output signal. This arrangement is, therefore, more sensitive to smaller changes in leakage current/TMR resistance and provides greater noise rejection. This circuit uses the fact that the TMR resistance is highest when the flux in the free layer and the pinned layer are opposite and is lowest when they are parallel. If, therefore, the two TMR devices 30", 30‴ are placed next to each other and oriented 180 degrees relative to each other, the resistance change in one TMR device would be opposite that of the other TMR device when subjected to the same flux.

Regardless of the circuit used to measure the resistance, the method of monitoring the TVS condition involves first obtaining a baseline resistance value for the TMR, by obtaining the voltage output when the TVS is new and storing this in e.g. non-volatile memory. During monitoring, while the TVS is in use, the TMR resistance will change as the TVS leakage current changes due to degradation and, therefore, the output voltage will change. This is compared to the baseline value to provide an indication of the TVS degradation.

In an example, the leakage for the new TVS can be recorded for different operation voltages and, if desired, for greater accuracy, the internal temperatures of the LRU are also recorded and these measurements are stored as fingerprints or signatures of the TVS. The leakage is then continuously or periodically monitored and compared with the stored signatures for the corresponding operational voltage and temperature. The deviation from the signature value is indicative of the degradation of the TVS and the TVS can be replaced based on this measurement - e.g. when the measured degradation exceeds a predetermined threshold value.

In an alternative, more sophisticated, scheme, rather than using only the leakage current of the TVS as an indicator of degradation, the leakage current harmonics/frequency spectra can be recorded as the initial signatures and subsequent harmonics/frequency spectra can be compared with these stored signatures to provide a more accurate and reliable indication of degradation, since the spectrum contains more information that can be identified by analysis of the spectrum.

The measured leakage currents can also be stored e.g. in non-volatile memory to provide a bank of information about lightning strikes and over-voltage events over the lifetime of the TVS.

The method and system of this disclosure allows a simple, passive TVS to be used in a wider range of applications because its degradation can be quickly, easily and reliably monitored without any down time and without the need to inject currents into the TVS device.

## Claims

1. A method of monitoring a change in leakage current through a transient voltage suppressor, TVS, device, the method comprising locating a tunnel magneto-resistance, TMR, device in proximity to the TVS device and measuring the change in resistance of the TMR device.

2. The method of claim 1, further comprising obtaining a baseline resistance value for the TMR device when the TVS has a baseline level of leakage current and comparing subsequent measures of the resistance of the TMR device with the baseline resistance value.

3. The method of claim 2, further comprising storing the baseline resistance value of the TMR device in memory.

4. The method of claim 2 or 3, further comprising storing the subsequent measures of resistance in memory.

5. The method of any preceding claim wherein the change in leakage current through the TVS device is used as an indication of degree of degradation of the TVS device.

6. The method of any preceding claim, wherein the step of measuring the change in resistance of the device is performed continuously.

7. The method of any preceding claim, wherein the step of measuring the change in resistance of the device is performed periodically.

8. The method of claim 2 or any claim dependent thereon, wherein the baseline resistance value comprises a plurality of baseline resistance values each associated with a given operation voltage and/or temperature and wherein the subsequent measures are compared with the baseline resistance value associated with the operation voltage and/or temperature at which the subsequent measurement was taken.

9. The method of claim 8, wherein the plurality of baseline resistance values are each associated with a frequency spectrum and the measured resistance values are also each associated with a frequency spectrum.

10. A system for monitoring the leakage current through a transient voltage suppression, TVS, device, the system comprising the TVS device (10) connected in a current conduction path and a tunnel-magnet-resistance, TMR, device (30) located proximate the TVS device, and means (40, 50) for measuring changes in the resistance of the TMR device during operation of the TVS device.

11. The system of claim 10, wherein the means for measuring comprises a voltage divider circuit including the TMR device, to provide a voltage indicative of the TMR device resistance, and an amplifier to amplify the voltage to provide an output voltage indicative of leakage current in the TVS device.

12. The system of claim 11, wherein the voltage divider circuit includes a voltage source (40) across which is connected, in series, the TMR device (30') and a resistor (50).

13. The system of claim 11, wherein the voltage divider circuit includes a voltage sensor (40) across which is connected, in series, the TMR device 30" and a second, oppositely directed TMR device 30"'.

14. The system of any of claims 10 to 13, wherein the TMR device comprises two layers of ferromagnetic material separated by a thin insulative layer.

15. The system of any of claims 10 to 14, further comprising a non-volatile memory for storing resistance and leakage current values.
